# EUROPÄISCHE PATENTSCHRIFT

(11) **EP 2 277 175 B1**
(45) Veröffentlichungstag und Bekanntmachung des Hinweises auf die Patenterteilung: **18.01.2012**
(21) Anmeldenummer: 09732681.3
(22) Anmeldetag: 25.03.2009
(51) Int. Cl.: G11C 11/14, G01R 33/09, G11B 5/66, G11C 13/02, H01F 10/32, H01L 27/22

(54) **VORRICHTUNG UND VERFAHREN ZUR ERZEUGUNG VON SCHALTBAREM TEMPORÄREM MAGNETISMUS IN OXIDISCHEN MATERIALIEN MITTELS ELEKTRISCHER FELDER**
APPARATUS AND METHOD FOR PRODUCING SWITCHABLE TEMPORARY MAGNETISM IN OXIDIC MATERIALS BY MEANS OF ELECTRICAL FIELDS
DISPOSITIF ET PROCÉDÉ DE PRODUCTION D'UN MAGNÉTISME TEMPORAIRE COMMUTABLE DANS DES MATÉRIAUX DE TYPE OXYDE À L'AIDE DE CHAMPS ÉLECTRIQUES

(30) Priorität: 15.04.2008 DE 102008019860
(43) Veröffentlichungstag der Anmeldung: 26.01.2011
(73) Patentinhaber: Technische Universität Dresden, 01069 Dresden (DE)
(72) Erfinder: MEYER, Dirk, 01326 Dresden (DE); LEISEGANG, Tilmann, 01097 Dresden (DE); STOECKER, Hartmut, 01069 Dresden (DE)
(74) Vertreter: Hempel, Hartmut
(86) Internationale Anmeldenummer: PCT/DE2009/000439
(87) Internationale Veröffentlichungsnummer: WO 2009/127187

(56) Entgegenhaltungen:
- DE-A1-102006 029 777
- US-A- 6 166 947
- CUONG ET AL.: "Oxygen Vacancy Clustering and Electron Localization in Oxygen-Deficient SrTiO3: LDA + U Study" PHYSICAL REVIEW LETTERS, Bd. 98, Nr. 115503, 16. März 2007 (2007-03-16), XP002537126 DOI: 10.1103/PhysRevLett.98.115503
- RUMAIZ ET AL.: "Experimental studies on vacancy induced ferromagnetism in undoped TiO2" SOLID STATE COMMUNICATIONS, SCIENCEDIRECT, ELSEVIER, Bd. 144, 7. September 2007 (2007-09-07), Seiten 334-338, XP0022310297 DOI: 10.1016/j.ssc.2007.08.034

## Beschreibung

Die Erfindung betrifft eine Vorrichtung und ein Verfahren zur Erzeugung von schaltbarem temporärem Magnetismus in oxidischen Materialien mittels elektrischer Felder.

In den letzten Jahren sind viele Untersuchungen an ferroelektrischen, ferromagnetischen und multiferroischen Materialien durchgeführt worden, z. B. an Nanometer-Schichtsystemen, bestehend aus verschiedenen ferroischen (ferromagnetischen, -elektrischen, -elastischen) Komponenten. Solche multiferroischen Materialien weisen eine Kopplung von unterschiedlichen ferroischen Eigenschaften auf, mit denen eine Vielzahl verschiedener Anwendungen möglich wird, z. B. mikroelektromechanische Systeme (MEMS), piezoelektrische Mikrosensoren und -aktuatoren, Mikrowellen-Elektronik, ferroelektrische Speicher (FRAM), ferroelektrische Feldeffekttransistoren, magnetoelektrische Umwandler usw. Die Kopplung von magnetischen und elektrischen Feldern ist somit nicht nur für grundlagenorientierte Untersuchungen, sondern auch aus technologischer Sicht für den großen Bereich der Magnetoelektronik und Spintronik von besonderem Interesse. Für die Spintronik, die unter anderem den Spinzustand von Elektronen als Informationsträger verwendet, ist insbesondere die Ausrichtung der Spins notwendig, die vorzugsweise extern durch Magnetfelder kontrolliert werden kann.

Es ist eine im Grunde ähnliche Vorrichtung und Anordnung zur Detektion von Röntgenstrahlung in der Druckschrift DE 10 2006 029 777 A1 beschrieben, wobei als wesentliches Element der Vorrichtung eine Anordnung mit einem Oxidkristall als oxidisches Material eingesetzt wird. Die Oxidkristallanordnung enthält einen Oxidkristall, der in Form einer planparallelen Platte ausgebildet ist und eine Dicke von etwa 500 µm aufweist. An den beiden gegenüberliegenden Plattenflächen des Oxidkristalls sind kontaktierende Elektroden angebracht, die aus metallisch leitenden Molybdän-Schichten mit einer Dicke von etwa 70 nm bestehen. Zwischen den beiden sich gegenüberliegenden Flächen des Oxidkristalls und den Molybdän-Elektroden befindet sich jeweils eine eingebrachte Borkarbid-Zwischenschicht mit einer Dicke von etwa 30 nm. An die Elektroden wird zur Beeinflussung der kristallinen Struktur in einer sich im Anodenbereich zwischen dem Oxidkristall und der zugehörigen Borkarbid-Zwischenschicht ausbildenden Wechselwirkungszone eine elektrische Gleichspannung in der Größenordnung bis zu einem Kilovolt angelegt. Das elektrische Leitverhalten kann durch einen in die Elektroden-Zuführungsleitungen eingebundenen Strommesser wiedergegeben werden, der insbesondere bei einer auf den Oxidkristall auftreffenden Röntgenstrahlung das Ansteigen des elektrischen Stromes als Nachweis der einfallenden Röntgenstrahlung anzeigt. Als Oxidkristall wird zur Registrierung der einfallenden Röntgenstrahlen Strontiumtitanat - SrTiO₃ - eingesetzt, das bei Raumtemperatur eine kubische Kristallsymmetrie aufweist.

Ein Problem besteht darin, dass mit dieser Anordnung kein Nachweis von Magnetismus und insbesondere einer Magnetisierung erfolgen kann.

Ein Verfahren zur Steuerung von Ferromagnetismus in einem magnetischen Halbleiter mittels eines elektrischen Feldes ist in der Druckschrift H. Ohno, D. Chiba, F. Matsukura, T. Omiya, E. Abe, T. Dietl, Y. Ohno, K. Ohtani: Electricfield control of ferromagnetism, Nature 408, S. 944-946 (2000) beschrieben, wobei das Schalten des loch-induzierten Ferromagnetismus des magnetischen Halbleiters (In,Mn)As durch ein elektrisches Feld beschrieben ist. Dafür sind allerdings Temperaturen um 30 K notwendig.

Ein Problem besteht darin, dass mit dem beschriebenen Material kein Schalten des Magnetismus bei Raumtemperatur (300 K) möglich ist.

Darstellungen zu einem durch Leerstellen induzierten Ferromagnetismus in undotierten TiO₂ sind in der Druckschrift A. K. Rumaiz, B. Ali, A. Ceylan, M. Boggs, T. Beebe, S. I. Shah: Experimental studies on vacancy induced ferromagnetism in undoped TiO2, Solid State Communications 144, S. 334-338 (2007) beschrieben, wobei der Ferromagnetismus im Oxidkristall TiO₂ bei verschiedenen Modifikationen durch Einfügen von Sauerstoff-Leerstellen bei der Herstellung hervorgebracht werden kann. Dazu wird bei der Erzeugung des Ferromagnetismus der umgebende Sauerstoff-Partialdruck gezielt eingestellt.

Ein Problem besteht darin, dass derartig modifizierte Kristalle es nicht erlauben, nach der Herstellung den Ferromagnetismus für funktionelle Elemente gezielt zu steuern.

Ein Verfahren zur Erzeugung von auf Sauerstoff-Leerstellen basierendem Ferromagnetismus ist in der Druckschrift Z. R. Xiao, G. Y. Guo, P. H. Lee, H. S. Hsu, J. C. A. Huang: Oxygen Vacancy Induced Ferromagnetism in V2O5-x, Journal of the Physical Society of Japan 77, S. 023706 (2008) beschrieben, wobei darin Berechnungen mit Hilfe der Dichtefunktionaltheorie zur Wirkung von Sauerstoff-Leerstellen in Vanadiumoxid V₂O₅ durchgeführt werden. Es wird der theoretische Nachweis erbracht, dass Ferromagnetismus in diesem Oxidkristall möglich ist, wenn Sauerstoff-Leerstellen in einer gewissen Konzentration vorliegen.

Ein Problem besteht darin, dass die Diffusion von Sauerstoff-Leerstellen durch ein elektrisches Feld nicht vorgesehen ist.

Eine Untersuchung von Sauerstoff-Leerstellen-Clustern und einer Elektronen-Lokalisierung in Strontiumtitanat ist in der Druckschrift D. D. Cuong, B. Lee, K. M. Choi, H.-S. Ahn, S. Han, J. Lee: Oxygen Vacancy Clustering and Electron Localization in Oxygen-Deficient SrTiO3 - LDA + U Study, Physical Review Letters 98, S. 115503 (2007) beschrieben, wobei Berechnungen zur Kopplung bzw. Anordnung von Sauerstoff-Leerstellen in Strontiumtitanat vorgestellt werden. Darin wird gezeigt, dass auch im mehrkomponentigen System SrTiO₃ eine Ausbildung von Ferromagnetismus möglich ist.

In dem Dokument US 6 166 947 A ist ein Magnesiumoxid beschrieben, das ein isolierendes antiferromagnetisches Material darstellt Bei einer Überlagerung eines elektrischen Feldes oder bei Durchfluss eines elektrischen Stromes kann eine Konvertierung zwischen dem isolierenden, antiferromagnetischen Material und einem nicht isolierenden, ferromagnetischen Material durchgeführt werden.

Ein Problem besteht darin, dass allerdings keine konkreten Schlussfolgerungen für die Bildung oder Ausrichtung von magnetischen Momenten gezogen worden sind.

Der Erfindung liegt die Aufgabe zugrunde, eine Vorrichtung und ein Verfahren zur Erzeugung von schaltbarem temporärem Magnetismus in oxidischen Materialien mittels elektrischer Felder anzugeben, die derart geeignet ausgebildet sind, dass auch und insbesondere bei Raumtemperatur eine Messung des magnetischen Zustands, insbesondere der Magnetisierung im potenzialbelasteten oxidischen Material gewährleistet wird, die damit zu einer Vielzahl makroskopischer Anwendungen führen kann.

Die Aufgabe wird mit den Merkmalen der Patentansprüche 1, 11 und 15 gelöst. In der Vorrichtung zur Erzeugung von schaltbarem temporärem Magnetismus in oxidischen Materialien mittels elektrischer Felder ist an zwei sich gegenüberliegenden Flächen des oxidischen Materials zumindest jeweils eine Elektrode angebracht, wobei bei Anlegen einer elektrischen Potenzialdifferenz das oxidische Material von dem elektrischen Feld E überlagert wird und damit eine Oxidmaterialanordnung vorhanden ist,
wobei Sauerstoff Leerstellen, die im oxidischen Material bereits vorhanden sind, bei Anlegen des elektrischen Feldes E im oxidischen Material umverteilt werden und sich somit ein Gradient der Sauerstoff-Konzentration einstellt, was zu einem messbaren elektrischen Strom im oxidischen Material führt,
wobei sich im Kathodenbereich zumindest unterhalb der kontaktierenden Oberfläche des oxidischen Materials eine Sauerstoff-Leerstellen-Zone mit erhöhter Sauerstoff-Leerstellen-Konzentration ausbildet,
wobei sich gemäß dem Kennzeichenteil des Patentanspruchs 1
in der Sauerstoff-Leerstellen-Zone die Valenz der Kationen des oxidischen Materials reduziert, wenn die Sauerstoff-Leerstellen-Konzentration zunimmt und sich erhöht, wenn die Sauerstoff-Leerstellen-Konzentration abnimmt,
wobei eine Reduktion der Valenz der Kationen im oxidischen Material magnetische Momente erzeugt, die entweder ungeordnet vorliegen, wodurch das oxidische Material paramagnetisch wird, oder untereinander koppeln, wodurch das oxidische Material dann entweder ferro-, ferri- oder antiferromagnetisch wird, und wobei unmittelbar außerhalb des Kathodenbereichs des oxidischen Materials und der Sauerstoff-Leerstellen-Zone zumindest eine Einrichtung zur Erfassung des sich in der Sauerstoff-Leerestellen-Zone durch das angelegte elektrische Feld E ausbildenden und registrierfähigen Magnetismus angeordnet ist.

Die Einrichtung zur Erfassung des sich in der Sauerstoff-Leerstellen-Zone durch das angelegte elektrische Feld E ausbildenden und registrierfähigen Magnetismus kann eine Sensoreinrichtung, einen Teil einer Speichereinrichtung oder einen Teil eines Schaltelements darstellen.

Zur Erhöhung der Sauerstoff-Leerstellen-Konzentration können positive Ionen ins Kristallgitter des oxidischen Materials eingebracht sein, wobei zur Verkürzung der Zeit der Erzeugung eines registrierfähigen Magnetismus die eingebrachten Ionen eine höhere Beweglichkeit oder höhere Diffusionskonstante aufweisen.

Zwischen den Elektroden und der zugehörigen Oberfläche des oxidischen Materials ist jeweils eine Zwischenschicht aus Borkarbid als Diffusionsbarriere angebracht.

Das elektrische Feld E bedingt die Änderung der Valenz bestimmter Kationen im Kathodenbereich des oxidischen Materials, wodurch magnetische Momente und damit zumindest Paramagnetismus entstehen, wobei zusätzlich durch Austauschwechselwirkung eine regelmäßige Ausrichtung der magnetischen Momente eine außerhalb des Kathodenbereichs messbare Magnetisierung M erzeugen kann, die mittels der auf Magnetismus reagierenden Einrichtung zur Erfassung des Magnetismus gemessen oder registriert wird. Die Änderung der Valenz und die dadurch bedingte Erzeugung von magnetischen Momenten, die untereinander koppeln, können damit einen Ferro-, Ferri- oder Antiferromagnetismus in dem oxidischen Material erzeugen.

Die als Sensoreinrichtung ausgebildete Einrichtung zur Erfassung des Magnetismus kann den magnetooptischen Kerreffekt ausnutzen, wobei eine Lichtquelle polarisiertes Licht ausstrahlt, das die gesamte Oxidmaterialanordnung, die aus dem oxidischen Material, den Elektroden, den Diffusionsbarrieren und der im oxidischen Material enthaltenden Sauerstoff-Leerstellen-Zone besteht, durchdringt, wobei das reflektierte Licht durch die in der Sauerstoff-Leerstellen-Zone vorhandene Magnetisierung ortsabhängig in Polarisation und Elliptizität verändert ist und wobei ein Detektor die Veränderungen ortsabhängig und damit die Magnetisierung M registriert.

Der im Stand der Technik beschriebene magnetooptische Kerreffekt gibt Zugang zum Magnetisierungsverhalten von verschiedenen Oxidmaterialanordnungen, die neben dem dünnen oxidischen Material die angebrachte Elektrodenanordnung enthält. Dieses zerstörungsfreie Verfahren arbeitet oberflächensensitiv in Reflexionsgeometrie, wobei aber der magnetooptische Faraday-Effekt dieselbe Messung der Magnetisierung M in Transmissionsgeometrie erlaubt.

Eine andere Einrichtung zur Erfassung des Magnetismus kann einen magnetischen Lesekopf darstellen, mit dem die Magnetisierung alternativ messbar ist. Der Lesekopf kann z. B. durch magnetische Induktion, durch einen magnetoresistiven Effekt oder durch einen Riesenmagnetwiderstand (GMR) die magnetische Information in der Oxidmaterialanordnung in eine Widerstandsänderung umwandeln, die dann gemessen wird.

Des Weiteren kann die Oxidmaterialanordnung in eine Spule zur Registrierung der Magnetisierung M, eingebracht sein, wobei die durch die Magnetisierung erzeugte magnetische Flussdichte B durch eine induzierte Spannung V in einem Voltmeter registriert wird. Dieser Aufbau erlaubt außerdem die Feststellung des magnetischen Zustandes des oxidischen Materials, wenn zwar magnetische Momente vorliegen, aber keine nach außen wirksame Magnetisierung, was im Falle des paramagnetischen Zustandes zutrifft. Eine entsprechende Feststellung kann durch Verändern eines extern angelegten Magnetfeldes und Auswerten der induzierten Spannung V erfolgen, da die magnetischen Momente im oxidischen Material mit dem externen Feld wechselwirken.

Als oxidisches Material können Oxidkristalle und Oxidkeramiken zumindest mit amorphen Anteilen eingesetzt werden. Beispielsweise können als oxidische Materialien Strontiumtitanat SrTiOₓ, Titanoxid TiOₓ und Vanadiumoxid VOₓ, Zirkoniumoxid ZrOₓ, Magnesiumoxid MgOₓ, Zinkoxid ZnOₓ, Zinnoxid SnOₓ, Ceroxid CeOₓ, Eisenoxid FeOₓ, Cobaltoxid CoOₓ, Wolframoxid WOₓ, Lanthanmanganat LaMnO_{X}, Indiumzinnoxid InSnO_{X}, Bariumtitanat BaTiOₓ, Calciumcarbonat CaCOₓ einsetzbar sein, wobei der Index x größer als Null und beliebig ist.

In dem Verfahren zur Erzeugung von schaltbarem temporärem Magnetismus in oxidischen Materialien mittels elektrischer Felder mit einer Vorrichtung nach Patentanspruch 1
werden gemäß dem Kennzeichenteil des Patentanspruchs 11
eine Änderung der Valenz der Kationen, primär durch die räumliche Umverteilung von Sauerstoff-Leerstellen mittels eines dem oxidischen Material überlagerten elektrischen Feldes E, bei Raumtemperatur und gleichzeitig eine regelmäßige Ausrichtung der magnetischen Momente zu einer resultierenden Magnetisierung M durchgeführt.

Zur Erhöhung der Sauerstoff-Leerstellen-Konzentration können positive Ionen ins Kristallgitter des oxidischen Materials eingebracht werden, wobei zur Verkürzung der Zeit der Erzeugung eines registrierfähigen Magnetismus die eingebrachten Ionen eine höhere Beweglichkeit oder höhere Diffusionskonstante aufweisen.

Durch die Wirkung zusätzlicher elektromagnetischer Felder können weitere Sauerstoff-Leerstellen in der Sauerstoff-Leerstellen-Zone und somit weitere magnetische Momente generiert werden.

Durch Anlegen des elektrischen Feldes (E) von etwa 1000 V/mm kann die Bildung von Sauerstoff-Leerstellen in der Sauerstoff-Leerstellen-Zone (4) von etwa 10 µm Dicke erfolgen.

Unter Verwendung des Verfahrens nach Anspruch 11 mit einer erfindungsgemäßen Vorrichtung nach Anspruch 1,
können gemäß Anspruch 15
die durch ein elektrisches Feld E erzeugten magnetischen Momente an äußere magnetische Felder koppeln, womit die Magnetisierung M schaltbar wird, was für Funktionselemente eingesetzt werden kann.

Die Oxidmaterialanordnung kann in einem magnetischen Speicher mit zwei Zuständen eingesetzt werden, wobei das Schreiben durch einen Schreibkopf entfällt, wenn als Zustand "0" das Vorhandensein beliebig ausgerichteter magnetischer Momente definiert wird und Zustand "1" das Fehlen dieser magnetischen Momente darstellt, wobei das Schreiben dann durch An- und Abschalten des elektrischen Feldes E und das Auslesen auf magnetischem Wege geschieht.

Die Oxidmaterialanordnung kann aber auch in einem magnetischen Speicher mit drei Zuständen eingesetzt werden, wobei bei anliegendem elektrischem Feld E die magnetischen Momente in der Sauerstoff-Leerstellen-Zone durch Anlegen eines externen Magnetfeldes zur konventionellen magnetischen Datenspeicherung verwendet werden, wobei das Auslesen des magnetischen Speichers wahlweise durch den magnetooptische Effekte oder konventionelle magnetische Leseköpfe erfolgt.

Des Weiteren kann die Oxidmaterialanordnung mit einem oxidischen Material in einem magnetisch speichernden Röntgendetektor als Sensoreinrichtung eingesetzt wird, wobei die auftreffenden Röntgenstrahlen punktuell zusätzliche magnetische Momente erzeugen, wobei mittels magnetooptischer Effekte oder magnetischer Leseköpfe dann Intensität und räumliche Verteilung der Röntgenstrahlung registriert werden, indem die Magnetisierung M ortsabhängig in der Sauerstoff-Leerstellen-Zone gemessen wird, wodurch die Intensität der eingefallenen Röntgenstrahlung messbar ist.

In einer weiteren Variante der Oxidmaterialanordnung kann sie mit einem oxidischen Material in einer magnetischen Positioniereinheit oder einem Magnetventil oder -schalter eingesetzt werden, wobei oberhalb des kontaktierten oxidischen Materials eine magnetisierbare Platte elastisch gelagert angebracht ist, wobei die im oxidischen Material durch ein externes elektrisches Feld E erzeugten magnetischen Momente mit den magnetischen Momenten in der magnetisierbaren Platte wechselwirken und so eine anziehende Kraft F auf die magnetisierbare Platte erzeugen, die sich dadurch nach unten bewegt oder bei Abschalten des elektrischen Feldes E wieder nach oben, womit die Durchflussgeschwindigkeit/-rate von Gasen und Flüssigkeiten steuerbar sind.

Außerdem kann die Oxidmaterialanordnung mit einem oxidischen Material für ein Kristallwachstum auf magnetischen Substraten eingesetzt werden, wobei durch ein externes Magnetfeld die im oxidischen Material statistisch verteilten magnetischen Momente vorgegeben ausgerichtet werden, wobei bei Abscheidung einer weiteren magnetisierbaren Schicht sowohl die Kristallstruktur durch epitaktisches Wachstum als auch die magnetische Struktur gezielt weitergegeben werden und nach der Beschichtung das Substrat durch Abschalten oder Umpolen des elektrischen Feldes E seine Magnetisierung M verliert.

Die Erfindung wird mittels Ausführungsbeispielen anhand von mehreren Zeichnungen näher erläutert.
Es zeigen:
- Fig. 1: einen schematischen Aufbau einer Vorrichtung zur Erzeugung von schaltbarem temporärem Magnetismus in oxidischen Materialien mittels elektrischer Felder mit einem oxidischen Material in Form einer Oxidmaterialanordnung im Querschnitt und einer Einrichtung zur Erfassung des Magnetismus in Form einer Sensoreinrichtung,
- Fig. 2: eine schematische Darstellung der Vorrichtung eines potenzialbelasteten oxidischen Materials in einer Oxidmaterialanordnung mit überlagertem elektrischen Feld mit einer umgebenden Spule zur Registrierung der Magnetisierung durch Messung der in der Spule induzierten Spannung,
- Fig. 3: das innere Funktionsprinzip in dem oxidischen Material, insbesondere in dessen Kathodenbereich, wobei
Fig. 3a das oxidische Material mit einer geringen Anzahl auf Fehlstellen basierender unregelmäßig angeordneter magnetischer Momente, die insgesamt ein unmagnetisiertes (nicht magnetisch geordnetes) oxidisches Material festlegen,
Fig. 3b die Oxidmaterialanordnung mit zusätzlichen durch das elektrische Feld erzeugten koppelnden magnetischen Momenten und einer daraus resultierenden Magnetisierung und
Fig. 3c die Oxidmaterialanordnung unter dem Einfluss von Röntgenstrahlung und Erzeugung weiterer magnetischer Momente zur Erhöhung der Magnetisierung
zeigen,
- Fig. 4: eine schematische Darstellung der Änderung der Titan-Valenz im SrTiO₃-Kristallkörper, wobei
Fig. 4a die Besetzung der äußeren Elektronenschalen eines freien Titan-Atoms,
Fig. 4b die Besetzung der äußeren Elektronenschalen eines vierfach positiv geladenen Titan-Ions in Oktaeder-Koordination in einem Strontiumtitanat-Festkörper,
Fig. 4c die Besetzung der äußeren Elektronenschalen eines dreifach positiv geladenen Titan-Ions in Tetraeder-Koordination im Strontiumtitanat-Festkörper und
Fig. 4d die Besetzung der äußeren Elektronenschalen eines dreifach positiv geladenen Titan-Ions in Tetraeder-Koordination im Strontiumtitanat-Festkörper mit einem kristallinternen Wasserstoffatom
zeigen,
- Fig. 5: eine schematische Darstellung der erfindungsgemäßen Vorrichtung mit einer Einrichtung zur Erfassung des Magnetismus in Form einer magnetischen Speicherzelle mit zwei Zuständen,
- Fig. 6: eine schematische Darstellung der erfindungsgemäßen Vorrichtung mit einer Einrichtung zur Erfassung des Magnetismus in Form einer magnetischen Speicherzelle mit drei Zuständen,
- Fig. 7: eine schematische Darstellung der erfindungsgemäßen Vorrichtung mit einer Einrichtung zur Erfassung des Magnetismus in Form eines magnetisch registrierenden Röntgendetektors und
- Fig. 8: eine schematische Darstellung der erfindungsgemäßen Vorrichtung mit einer Einrichtung zur Erfassung des Magnetismus in Form einer magnetischen Positioniereinheit oder eines Magnetventils.

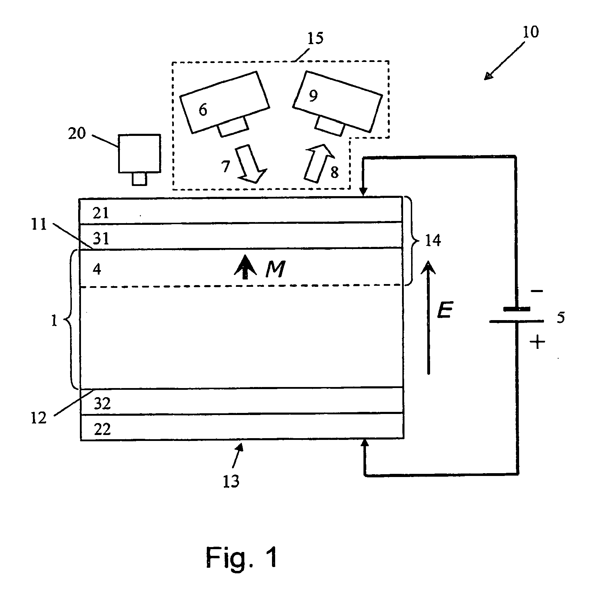

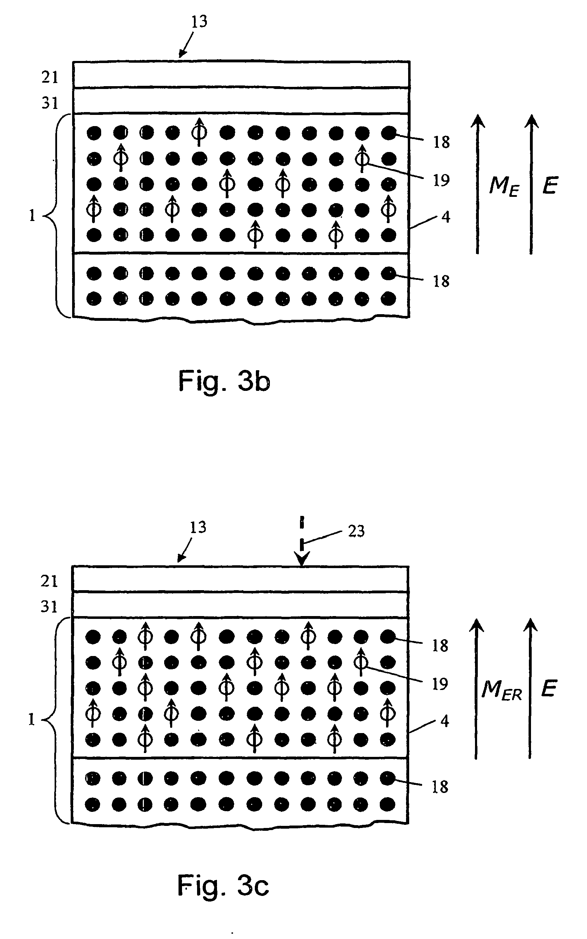

Im Folgenden werden die Fig. 1 und Fig. 3b und 3c gemeinsam betrachtet.

In der in Fig. 1 dargestellten Vorrichtung 10 zur Erzeugung von schältbarem temporärem Magnetismus in oxidischen Materialien 1 mittels eines elektrischen Feldes E ist an zwei sich gegenüberliegenden Flächen 11, 12 des oxidischen Materials 1 zumindest jeweils eine Elektrode 21, 22 angebracht, wobei bei Anlegen einer elektrischen Potenzialdifferenz das oxidische Material 1 von dem elektrisches Feld E überlagert wird und damit eine Oxidmaterialanordnung 13 vorhanden ist,
wobei sich im Kathodenbereich 14 des oxidischen Materials 1 zumindest unterhalb der kontaktierenden Oberfläche 11 des oxidischen Materials 1 eine Sauerstoff-Leerstellen-Zone 4 ausbildet, und
wobei die Sauerstoff-Leerstellen zu einem Strom im oxidischen Material 1 führen.

Erfindungsgemäß ist unmittelbar außerhalb des Kathodenbereichs 14 des oxidischen Materials 1 und der Sauerstoff Leerstellen-Zone 4 zumindest eine Einrichtung 15, 20 zur Erfassung des Magnetismus des sich in der Sauerstoff-Leerstellen-Zone 4 durch das angelegte elektrische Feld E ausbildenden und registrierfähigen Magnetismus angeordnet ist,
wobei eine Änderung der Valenz der Kationen des oxidischen Materials 1 in der Sauerstoff-Leerstellen-Zone 4 magnetischen Momente 19 hervorbringt, die zumindest Paramagnetismus bedingen oder auch untereinander koppeln und damit einen sich außerhalb des oxidischen Materials 1 ausbreitenden Ferro-, Ferri-oder Antiferromagnetismus erzeugen und
wobei die Änderung der Valenz von Kationen in der Sauerstoff-Leerstellen-Zone 4 durch eine räumliche Umverteilung von Sauerstoff-Leerstellen im oxidischen Material 1 entsteht.

Die Einrichtung 15, 20 zur Erfassung des sich in der Sauerstoff-Leerstellen-Zone 4 durch das angelegte elektrische Feld E ausbildenden und registrierfähigen Magnetismus kann eine Sensoreinrichtung, einen Teil einer Speichereinrichtung oder einen Teil eines Schaltelements darstellen.

Die Sauerstoff Leerstellen-Zone 4 stellt eine Zone verringerter Sauerstoff-Konzentration dar, womit in dieser Zone die Konzentration der Sauerstoff Leerstellen erhöht ist und ein Sauerstöffdefizit herrscht. Des Weiteren kann in dieser Zone ein Konzentrationsgradient senkrecht zur Oberfläche vorliegen.

Zwischen den Elektroden 21, 22 und der zugehörigen Oberfläche 11, 12 des oxidischen Materials 1 kann jeweils eine Zwischenschicht 31, 32 aus Borkarbid als Diffusionsbarriere angebracht sein.

Die Änderung der Valenz bestimmter Kationen im Kathodenbereich 14 des oxidischen Materials 1 führt zur Erzeugung von magnetischen Momenten, wodurch das oxidische Material zunächst paramagnetisch wird. Koppeln die magnetischen Momente untereinander, können sie damit Ferro-, Ferri-oder Antiferromagnetismus in dem oxidischen Material 1 erzeugen.

Das in Fig. 1 dargestellte oxidische Material 1 ist an seiner Oberseite 11 und seiner Unterseite 12 mit den Elektroden 21, 22 versehen, die aber durch die Diffusionsbarrieren 31, 32 vom oxidischen Material 1 selbst getrennt sind. In der dünnen Sauerstoff-Leerstellen-Zone 4 im Kathodenbereich zur Oberfläche 11 des oxidischen Materials 1 kommt es durch Anlegen einer elektrischen Spannung mittels einer Energieversorgungseinheit 5 und damit des elektrischen Feldes E zu strukturellen Änderungen. Das elektrische Feld E bewirkt unter anderem die Entstehung magnetischer Momente 19, welche sich gekoppelt ausrichten und damit eine Magnetisierung M, die z. B. mittels der auf Magnetisierung reagierenden Sensoreinrichtung 15, 20 gemessen bzw. registriert werden kann.

Die Einrichtung zur Erfassung des Magnetismus in Form einer Sensoreinrichtung 15 kann den magnetooptischen Kerreffekt ausnutzen. Dazu strahlt eine Lichtquelle, vorzugsweise ein Laser 6, polarisiertes Licht 7 aus, das die gesamte Oxidmaterialanordnung 13, die aus dem oxidischen Material 1, den Elektroden 21, 22, den Diffusionsbarrieren 31, 32 und der im oxidischen Material 1 enthaltenen Sauerstoff-Leerstellen-Zone 4 besteht, durchdringt. Das reflektierte Licht 8 ist durch die in der Sauerstoff-Leerstellen-Zone 4 vorhandene Magnetisierung M ortsabhängig in Polarisation und Elliptizität verändert. Ein Detektor 9 kann diese Veränderungen ortsabhängig und damit die Magnetisierung M registrieren.

Eine andere in Fig. 1 gezeigte Einrichtung zur Erfassung des Magnetismus 20 kann einen magnetischen Lesekopf darstellen, mit dem die Magnetisierung M alternativ messbar ist. Der Lesekopf 20 kann z. B. durch magnetische Induktion, durch einen magnetoresistiven Effekt oder durch einen Riesenmagnetwiderstand die magnetische Information in der Oxidmaterialanordnung 13 in eine Widerstandsänderung umwandeln, die dann gemessen wird.

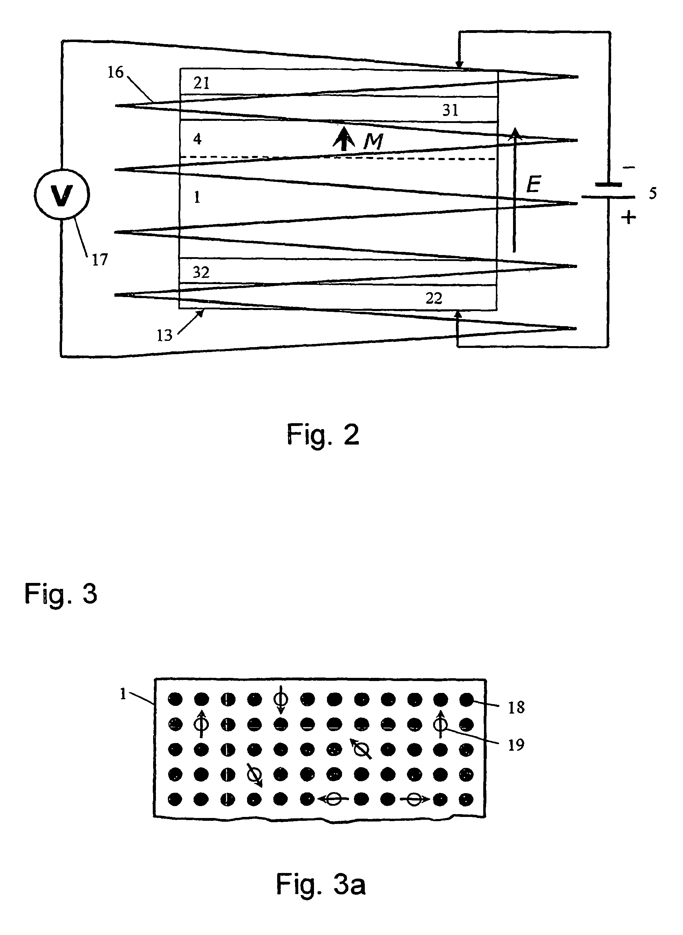

Alternativ kann, wie in Fig. 2 gezeigt ist, die Oxidmaterialanordnung 13 in eine Spule 16 zur Registrierung der Magnetisierung M, eingebracht sein, wobei die durch die Magnetisierung erzeugte magnetische Flussdichte B eine Spannung V induziert, die in einem Voltmeter 17 registriert werden kann.

In den Fig. 3 werden das innere, auf die Erfindung bezogene Funktionsprinzip in dem oxidischen Material 1, insbesondere in dessen Sauerstoff-Leerstellen-Zone 4 im Kathodenbereich 14 der Oxidmaterialanordnung 13 dargestellt, wobei in Fig. 3a zum Vergleich das ohne angelegtes elektrisches Feld angegebene oxidische Material 1 mit auf vereinzelt existierenden Sauerstoff-Leerstellen basierenden unregelmäßig angeordneten magnetischen Momenten 19, die insgesamt ein unmagnetisiertes oxidisches Material 1 festlegen, gezeigt wird.

Die Fig. 3b zeigt einen Teil der Oxidmaterialanordnung 13 mit zusätzlich durch das angelegte elektrische Feld entstandenen, weiteren magnetischen Momenten 19 und deren regelmäßige Ausrichtung, die zur Magnetisierung M_{E} führt. In der in Fig. 3b dargestellten Sauerstoff-Leerstellen-Zone 4 des oxidischen Materials 1 wird das Gitter der Sauerstoff-Atome 18 durch Anlegen des elektrischen Feldes E gestört. Nahe den Sauerstoff-Leerstellen kann sich die Valenz der angrenzenden Kationen des oxidischen Materials 1 ändern, wodurch an diesen Stellen die zusätzlichen magnetischen Momente 19 entstehen, die sich verglichen mit dem Ausgangszustand in Fig. 3a zu einer resultierenden Magnetisierung M_{E} addieren.

In Fig. 3c wird der gleiche Teil der Oxidmaterialanordnung 13 unter dem zusätzlichen Einfluss von Röntgenstrahlung 23 und damit die Erzeugung weiterer magnetischer Momente 19 zur Erhöhung der Magnetisierung M_{ER} gezeigt, wobei das angelegte elektrische Feld E konstant bleiben soll.

Als oxidisches Material 1 kann ein Einkristall aus Strontiumtitanat SrTiO₃ eingesetzt sein, der mit den Elektroden 21, 22 aus Wolfram versehen ist. Der Einkristall aus Strontiumtitanat SrTiO₃ weist in (100)-Orientierung die Abmaße 10 x 10 x 0,5 mm auf, wobei die Dicke 0,5 mm beträgt. Der Einkristall 1 wird beidseitig mit Diffusionsbarrieren 31, 32 aus Borkarbid B₄C von 30 nm Dicke und den Wolfram-Elektroden 21, 22 von 70 nm Dicke beschichtet. Durch Anlegen eines elektrischen Feldes E von 1000 V/mm erfolgt durch den Transport einzelner Sauerstoff-Atome die zusätzliche Ausbildung von Sauerstoff-Leerstellen in der Sauerstoff-Leerstellen-Zone 4 von etwa 10 µm Dicke. Dies lässt sich durch eine Änderung der mittleren Titan-Valenz von Ti⁴⁺ nach Ti³⁺ bei erhöhter Sauerstoff-Leerstellen-Konzentration in der Sauerstoff-Leerstellen-Zone 4 registrieren. Abschalten oder Umpolen des elektrischen Feldes E führt dazu, dass die Sauerstoff-Leerstellen-Konzentration wieder abnimmt und insbesondere die mittlere Titan-Valenz von Ti³⁺ nach Ti⁴⁺ wechselt.

Weitere Beispiele für derart geeignete oxidische Materialien können neben Strontiumtitanat SrTiOₓ auch Titanoxid TiOₓ und Vanadiumoxid VOₓ, Zirkoniumoxid ZrOₓ, Magnesiumoxid MgOₓ, Zinkoxid ZnOₓ, Zinnoxid SnOₓ, Ceroxid CeOₓ, Eisenoxid FeOₓ, Cobaltoxid CoOₓ, Wolframoxid WOₓ, Lanthanmanganat LaMnOₓ, Indiumzinnoxid InSnOₓ, Bariumtitanat BaTiOₓ, Calciumcarbonat CaCOₓ sein, wobei der Index *x* größer als Null und beliebig ist. Diese chemischen Verbindungen können sowohl in kristalliner als auch in partiellkristalliner oder amorpher Form (Oxidkeramiken) enthalten sein.

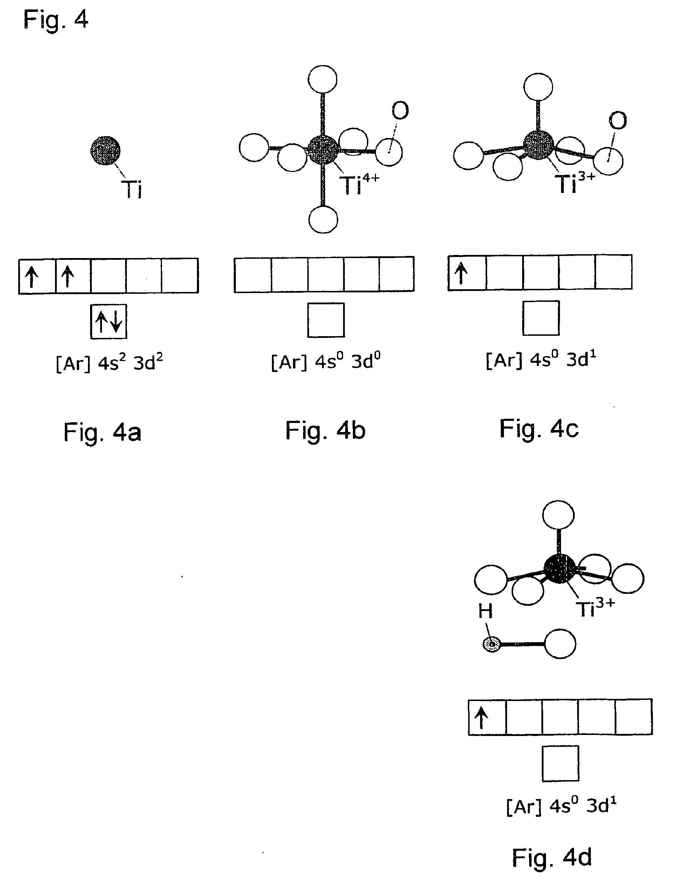

In den Fig. 4 mit Fig. 4a, Fig. 4b, Fig. 4c ist zur Erklärung der Kationen-Anionen-Beziehungen jeweils ein Titan-Atom mit verschiedenen Umgebungen und die zugehörige Besetzung der äußeren Elektronenschalen 4s und 3d dargestellt. Fig. 4a zeigt ein freies Titan-Atom, das keine Elektronen für die Bindung abgegeben hat. In Fig. 4b ist die Oktaeder-Koordination des Titan-Atoms im Strontiumtitanat SrTiO₃ durch sechs Sauerstoff-Atome dargestellt, wodurch Titan im Zustand Ti⁴⁺ vorliegt. Wird, wie in Fig. 4c gezeigt, eines der Sauerstoff-Atome entfernt und durch eine Sauerstoff-Leerstelle ersetzt, ändert sich dieser Zustand zu Ti³⁺ und die 3d-Schale enthält ein Elektron. Demgemäß existiert nun wegen des Gesamtdrehimpulses *J* ≠ 0 ein magnetisches Moment. Liegt eine Vielzahl von Sauerstoff-Leerstellen vor, so existiert damit gleichzeitig eine Vielzahl von magnetischen Momenten, die durch Austauschwechselwirkung über die angrenzenden Sauerstoff-Atome oder Sauerstoff-Leerstellen ferro-, ferri- oder antiferromagnetisch koppeln und so eine resultierende Magnetisierung erzeugen.

Durch den Wechsel von Ti⁴⁺ zu Ti³⁺ bleibt ein Elektron ungepaart, wodurch ein magnetisches Moment für dieses Atom resultiert, wie in den Fig. 4b und 4c gezeigt ist. Dieses magnetische Moment kann dann mit anderen koppeln, wodurch ein resultierender Magnetismus bei Anlegen eines elektrischen Feldes ausgebildet werden kann.

Der Vorzug von eingebrachten positiven Ionen, wie z. B. Wasserstoff-Ionen, die ein Sauerstoff-Ion binden, wie auch in Fig. 4d gezeigt ist, ist deren höhere Beweglichkeit im Kristallgitter verglichen mit den Sauerstoff-Leerstellen. Bei Anwesenheit von Wasserstoff werden dann OH-Komplexe gebildet, die ebenso wie Sauerstoff-Leerstellen wirken, d. h. die Valenz von Titan von Ti⁴⁺ zu Ti³⁺ ändern. Dadurch kann der Magnetismus schneller geschalten werden - die Schaltzeit ist dabei abhängig von Beweglichkeit bzw. Diffusionskonstante der eingebrachten Ionen und deren Anzahl. Zudem kann die notwendige elektrische Feldstärke verringert und die Stärke des erzeugten resultierenden Magnetismus vergrößert werden. Die genannten positiven Eigenschaften sind abhängig von Art und Anzahl der positiven Ionen. Entscheidend für die Auswahl einer Ionensorte ist die Diffusionskonstante der positiven Fremd-Ionen im oxidischen Material.

Die Fremd-Ionen können in das oxidische Material auf verschiedenen Wegen eingebracht werden.

Bei Einsatz einer porösen Elektrode, d. h. die für die zu verwendende Fremdlonensorte durchlässig ist, können die Fremd-Ionen direkt von außen in Lösung oder in Molekülen gebunden aufgebracht werden. Getrieben vom angelegten elektrischen Feld werden die Moleküle gespalten und die Fremd-Ionen dringen ins oxidische Material ein. Beispielsweise ist es für Wasserstoff-Ionen ausreichend, Wasser aus der Luft (Luftfeuchtigkeit), das an der Probe bereits vorhanden ist, im elektrischen Feld durch Elektrolyse zu spalten, wodurch der Sauerstoff entweicht und der Wasserstoff ins oxidische Material eindringen kann. Wasserstoff-Ionen können zudem durch Anätzen der Oberfläche mit einer Säure in das oxidische Material gelangen.

Alternativ und für den Fall dichter Elektroden, kann die gewünschte Fremdlonensorte vor den Elektroden auf das oxidische Material aufgebracht oder in das oxidische Material eingebracht werden. Das Einbringen kann dabei z. B. durch Erwärmen in einer entsprechenden Atmosphäre geschehen.

Für den Fall von Wasserstoff in Strontiumtitanat beträgt die Diffusionskonstante bei 1000 K etwa 3,8 x 10⁻⁵ cm²/s, die in der Druckschrift R. Waser: Diffusion of Hydrogen Defects in BATiO3-Ceramics and SrTiO3 Single Cystals, Ber. Bunsenges. Phys. Chem. 90 (1986), S. 1223-1230 angegeben ist. Im Vergleich dazu ist die Diffusionskonstante von Sauerstoff bei dieser Temperatur mit 4,7 x 10⁻¹² cm²/s, wie sie in der Druckschrift A.E. Paladino, L.G. Rubin, J. S. Waugh: Oxygen ion diffusion in single crystal SrTiO3, Journal of Physics and Chemistry of Solids 26 (1965), S. 391-397 angegeben ist, wesentlich geringer. Übertragen auf die Diffusionskonstanten bei Raumtemperatur kann von einem ähnlich großen Unterschied ausgegangen werden, so dass die Beweglichkeit des Wasserstoffs in Strontiumtitanat einige Größenordnungen über der des Sauerstoffs liegt, so dass schon bei wenigen Wasserstoff-Ionen messbare Auswirkungen vorhanden sind. Bei ausreichender Beladung des Strontiumtitanat-Substrats mit Wasserstoff wird demzufolge eine Verkürzung der Schaltzeiten des Magnetismus zumindest von einer Größenordnung erreicht

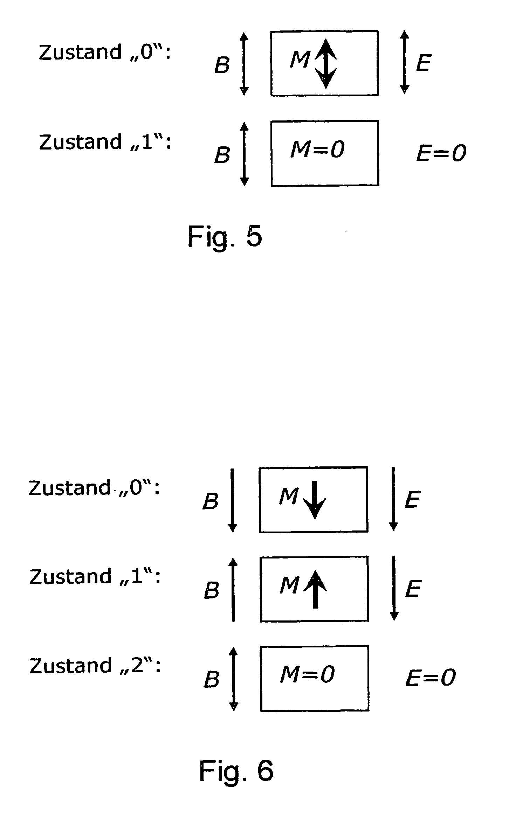

Dadurch kann, wie in Fig. 5 gezeigt ist, in einem ersten Anwendungsbeispiel der Vorrichtung und des Verfahrens ein magnetischer Speicher mit zwei Zuständen angegeben werden. Ohne angelegtes elektrisches Feld E existiert nur eine geringe Anzahl von unregelmäßig angeordneten magnetischen Momenten; somit tritt keine Magnetisierung auf. Wird das elektrische Feld E eingeschaltet, so werden zusätzliche magnetische Momente erzeugt, die durch Wechselwirkung miteinander eine resultierende Magnetisierung M ergeben. Dies kann zur konventionellen magnetischen Datenspeicherung verwendet werden, wenn als Zustand "0" das Vorhandensein einer beliebigen Magnetisierung M definiert wird und als Zustand "1" das Fehlen jeglicher Magnetisierung M. Das Schreiben wird dann durch An- und Abschalten des elektrischen Feldes E geschehen und das Auslesen des magnetischen Speichers kann wie oben beschrieben, durch den magnetooptischen Kerreffekt oder konventionelle magnetische Leseköpfe 18 erfolgen. Eine magnetische Flussdichte B könnte jeweils beliebig orientiert sein, ist jedoch nicht erforderlich.

In einem in Fig. 6 gezeigten zweiten Anwendungsbeispiel der erfindungsgemäßen Vorrichtung mit einem magnetischen Speicher mit drei Zuständen kann zunächst wie zuvor vorgegangen werden. Der magnetisierte Zustand wird hier allerdings unterteilt und ein beispielsweise nach unten ausgerichtetes magnetisches Moment definiert dann den Zustand "0" und ein nach oben ausgerichtetes den Zustand "1". Diese Information kann durch eine magnetische Flussdichte B beispielsweise durch einen konventionellen magnetischen Schreibkopf gesetzt werden. Wird das elektrische Feld E abgeschaltet, gehen alle gespeicherten Informationen verloren, was zum einen als Löschfunktion eingesetzt werden kann, aber zum anderen auch einen dritten Zustand repräsentiert. Der dritte Zustand "2" wird dann durch Fehlen jeglicher Magnetisierung M definiert. Das Auslesen des magnetischen Speichers kann wie oben beschrieben, durch den magnetooptischen Kerreffekt oder konventionelle magnetische Leseköpfe 18 erfolgen.

Für die Zustände "0" und "1" muss ein elektrisches Feld E angelegt sein. Die Ausrichtung der Magnetisierung M wird durch eine magnetische Flussdichte B geschrieben und kann anschließend ausgelesen werden. Eine nach unten ausgerichtete Magnetisierung repräsentiert dabei den Zustand "0" und eine nach oben ausgerichtete den Zustand "1". Die Richtung des elektrischen Feldes E wird dabei nicht geändert. Wird das elektrische Feld E abgeschaltet, geht die magnetische Information verloren und die Magnetisierung verschwindet, was als Zustand "2" ausgelesen werden kann. Eine beliebige magnetische Flussdichte B hat auf Zustand "2" keinen Einfluss.

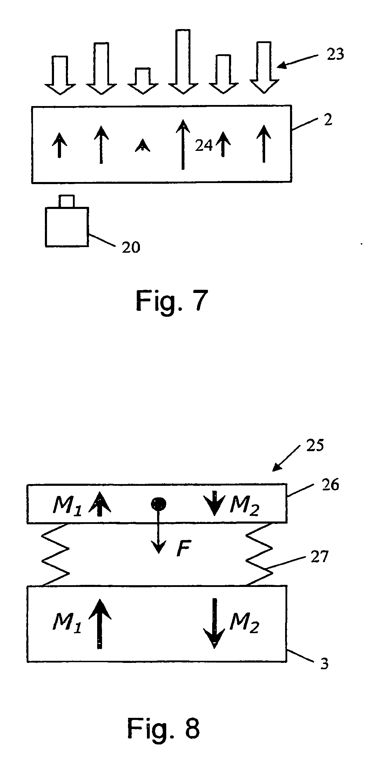

In einem dritten Anwendungsbeispiel der erfindungsgemäßen Vorrichtung mit einem magnetisch speichernden Röntgendetektor 20 kann, wie in Fig. 7 gezeigt ist, die erfindungsgemäße Oxidmaterialanordnung gemäß der im Stand der Technik genannten Druckschrift DE 102006029777 A1, aber mit umgekehrter Polung des angelegten elektrischen Feldes E eingesetzt werden, wobei die Röntgenstrahlen in bestimmten oxidischen Materialien 2 strukturelle Änderungen verursachen. Die Wirkung der Röntgenstrahlung kann erfindungsgemäß mit der Erzeugung magnetischer Momente einhergehen, die dann wie oben beschrieben registrierbar sind. Damit ergibt sich ein ortsauflösender Röntgendetektor 20, dessen Abmessungen von der Größe des verwendeten oxidischen Materials 2 abhängen.

Die auftreffende Röntgenstrahlung 23 erzeugt punktuell zusätzliche magnetische Momente 24 im zweiten oxidischen Material 2. Mittels magnetooptischer Effekte oder magnetischer Leseköpfe können dann Intensität und räumliche Verseilung der auftreffenden Röntgenstrahlung 23 rekonstruiert werden, indem die Verteilung der Magnetisierung M mit einem Detektor 20 punktweise und ortsabhängig in der Sauerstoff-Leerstellen-Zone 4 gemessen wird.

In einem vierten Anwendungsbeispiel der erfindungsgemäßen Vorrichtung mit einer magnetischen Positioniereinheit 25 oder eines Magnetventils bzw. -schalters, wie in Fig. 8 gezeigt, wird über dem kontaktierten dritten oxidischen Material 3 eine magnetisierbare Platte 26 z. B. auf Federn 27 elastisch gelagert angebracht. Die im dritten oxidischen Material 3 durch ein externes elektrisches Feld E erzeugten magnetischen Momente erzeugen ihrerseits eine magnetische Flussdichte B, welche die magnetischen Momente in der Platte 26 ausrichtet und somit eine anziehende Kraft F auf die magnetisierbare Platte 26 ausübt, die sich dadurch nach unten bewegt bzw. bei Abschalten des elektrischen Feldes E wieder nach oben. Die Magnetisierung des oxidischen Materials 3 kann entweder in Richtung M₁ oder M₂ erfolgen, wodurch eine entsprechende Magnetisierung in der magnetisierbaren Platte 26 entsteht. Auf diese Weise kann das angelegte elektrische Feld E zur eindimensionalen Positionierung der Platte 26 genutzt werden. Weiterhin kann die Größe des Hohlraums zwischen dem dritten oxidischen Material 3 und der magnetisierbaren Platte 26 gezielt eingestellt werden. Damit wird die Größe des Hohlraums zwischen Platte 26 und drittem oxidischen Material 3 und so die Durchflussgeschwindigkeit/-rate von durchströmenden Gasen oder Flüssigkeiten steuerbar. Zusätzlich kann diese Positioniereinheit 25 auch als Magnetventil oder -schalter eingesetzt werden.

Die zweiten und dritten oxidischen Materialien 2 und 3 können sich wie das erste oxidische Material 1 in einer Oxidmaterialanordnung 13 befinden.

In einem fünften Anwendungsbeispiel der erfindungsgemäßen Vorrichtung kann die erfindungsgemäße Oxidmaterialanordnung 13 für ein Kristallwachstum auf magnetischen Substraten eingesetzt werden. Durch ein externes Magnetfeld werden die im oxidischen Materials 1 statistisch verteilten magnetischen Momente ausgerichtet, z. B. senkrecht zur Schichtebene. Wird nun eine weitere magnetisierbare Schicht abgeschieden, kann sowohl die Kristallstruktur durch epitaktisches Wachstum als auch die magnetische Struktur gezielt weitergegeben werden. Nach der Abscheidung kann durch Abschalten des elektrischen Feldes E die Magnetisierung des Substrats entfernt werden.

### Bezugszeichenliste

- 1: Erstes oxidisches Material
- 2: Zweites oxidisches Material
- 3: Drittes oxidisches Material
- 4: Sauerstoff-Leerstellen-Zone
- 5: Energieversorgungseinheit
- 6: Laser
- 7: Einfallendes polarisiertes Licht
- 8: Reflektiertes Licht
- 9: Detektor
- 10: Vorrichtung
- 11: Erste Oberfläche
- 12: Zweite Oberfläche
- 13: Oxidmaterialanordnung
- 14: Kathodenbereich
- 15: Einrichtung zur Erfassung des Magnetismus
- 16: Spule
- 17: Voltmeter
- 18: Sauerstoff Atom
- 19: Magnetisches Moment
- 20: Sensoreinrichtung
- 21: Kathode
- 22: Anode
- 23: Röntgenstrahlen
- 24: Magnetische Momente
- 25: Positioniereinheit
- 26: Magnetisierbare Platte
- 27: Federn
- 31: Erste Diffusionsbarriere
- 32: Zweite Diffusionsbarriere
- B: Magnetflussdichte
- M: Magnetisierung
- E: Elektrisches Feld
- F: Kraft
- V: induzierte Spannung

## Patentansprüche

1. Vorrichtung zum Speichern von Daten, bestehend aus
einer Vorrichtung zur Erzeugung von schaltbarem temporärem Magnetismus in einem oxidischen Material mittels elektrischer Felder,
mindestens einem Speicherelement (13), bestehend aus dem oxidischen Maserial und an zwei sich gegenüberliegenden Flächen (11,12) des oxidischen Materials (1,2,3) zumindest jeweils einer angebrachten Elektrode (21,22), wobei bei Anlegen einer elektrischen Potenzialdifferenz das oxidische Material (1,2,3) von dem elektrischen Feld (E) überlagert wird und damit eine Oxidmaterialanordnung (13) vorhanden ist,
wobei Sauerstoff-Leerstellen, die im oxidischen Material (1,2,3) bereits vorhanden sind, bei Anlegen des elektrischen Feldes (E) im oxidischen Material (1,2,3) umverteilt werden und sich somit ein Gradient der Sauerstoff Konzentration einstellt, was zu einem messbaren elektrischen Strom im oxidischen Material (1,2,3) führt,
wobei sich in einem Kathodenbereich (14) des Speicherelementes (13) zumindest unterhalb einer kontaktierenden Oberfläche (11) des oxidischen Materials (1,2,3) eine Sauerstoff-Leerstellen-Zone (4) mit erhöhter Sauerstoff-Leerstellen-Konzentration ausbildet,
**dadurch gekennzeichnet,**
**dass** sich in der Sauerstoff-Leerstellen-Zone (4) die Valenz der Kationen des oxidischen Materials (1,2,3) reduziert, wenn die Sauerstoff-Leerstellen-Konzentration zunimmt und sich erhöht, wenn die Sauerstoff-Leerstellen-Konzentration abnimmt,
wobei eine Reduktion der Valenz der Kationen im oxidischen Material (1,2,3) magnetische Momente (19) erzeugt, die entweder ungeordnet vorliegen, wodurch das oxidische Material (1,2,3) paramagnetisch wird, oder untereinander koppeln, wodurch das oxidische Material (1,2,3) dann entweder ferro-, ferri-oder antiferromagnetisch wird, und
zumindest eine Einrichtung (15, 20) zur Erfassung der sich in der Sauerstoff Leerstellen-Zone (4) durch das angelegte elektrische Feld (E) ausbildenden und registrierfähigen magnetischen Momente (19) unmittelbar außerhalb des Kathodenbereichs (14) des oxidischen Materials (1,2,3) und der Sauerstoff-Leerstellen-Zone (4) angeordnet ist.

2. Vorrichtung nach Anspruch 1,
**dadurch gekennzeichnet,**
**dass** die Einrichtung (15, 20) zur Erfassung des sich in der Sauerstoff-Leerstellen-Zone (4) durch das angelegte elektrische Feld (E) ausbildenden und registrierfähigen Magnetismus eine Sensoreinrichtung, einen Teil einer Speichereinrichtung oder einen Teil eines Schaltelements darstellt.

3. Vorrichtung nach Anspruch 1 oder 2,
**dadurch gekennzeichnet,**
**dass** zur Erhöhung der Sauerstoff-Leerstellen-Konzentration positive Ionen ins Kristallgitter des oxidischen Materials eingebracht sind, wobei zur Verkürzung der Zeit der Erzeugung eines registrierfähigen Magnetismus die eingebrachten Ionen eine höhere Beweglichkeit oder höhere Diffusionskonstante aufweisen.

4. Vorrichtung nach mindestens einem der Ansprüche 1 bis 3,
**dadurch gekennzeichnet,**
**dass** zwischen den Elektroden (21,22) und der zugehörigen Oberfläche (11,12) des oxidischen Materials (1,2,3) jeweils eine Zwischenschicht (31,32) aus Borkarbid als Diffusionsbarriere angebracht ist.

5. Vorrichtung nach Anspruch 1,
**dadurch gekennzeichnet,**
**dass** das elektrische Feld (E) magnetische Momente (19), deren regelmäßige Ausrichtung und damit eine Magnetisierung (M) erzeugt, die mittels der auf Magnetismus reagierenden Einrichtung (15,20) gemessen oder registriert wird.

6. Vorrichtung nach Anspruch 2,
**dadurch gekennzeichnet,**
**dass** die Sensoreinrichtung (15) den magnetooptischen Kerreffekt oder Faradayeffekt ausnutzt, wobei eine Lichtquelle (6) polarisiertes Licht (7) ausstrahlt, das die gesamte Oxidmaterialanordnung (13), die aus dem oxidischen Material (1,2,3), den Elektroden (21,22), den Diffusionsbarrieren (31,32) und der im oxidischen Material (1,2,3) enthaltenen Sauerstoff Leerstellen-Zone (4) besteht, durchdringt, wobei das reflektierte oder transmittierte Licht (8) durch die in der Sauerstoff-Leerstellen-Zone (4) vorhandene Magnetisierung (M) ortsabhängig in Polarisation und Elliptizität verändert ist und wobei ein Detektor (9) die Veränderungen und damit die erzeugte Magnetisierung (M) ortsabhängig registriert.

7. Vorrichtung nach Anspruch 1,
**dadurch gekennzeichnet,**
**dass** die Einrichtung (20) zur Erfassung des Magnetismus einen magnetischen Lesekopf darstellt, mit dem alternativ die Magnetisierung (M) messbar ist.

8. Vorrichtung nach Anspruch 7,
**dadurch gekennzeichnet,**
**dass** alternativ die Oxidmaterialanordnung (13) in eine Spule (16) zur Registrierung der Magnetisierung (M), eingebracht wird, die das durch die Magnetisierung erzeugte Magnetfeld durch eine induzierte Spannung (V) in einem Voltmeter (17) registriert.

9. Vorrichtung nach Anspruch 7,
**dadurch gekennzeichnet,**
**dass** alternativ die Oxidmaterialanordnung (13) in eine Spule (16) zur Registrierung des magnetischen Zustandes, eingebracht wird, welche die durch ein äußeres Magnetfeld angeregte Magnetisierung (M) durch eine induzierte Spannung (V) in einem Voltmeter (17) registriert.

10. Vorrichtung nach Anspruch 1,
**dadurch gekennzeichnet,**
**dass** als oxidisches Material (1,2,3) Strontiumtitanat SrTiOₓ, Titanoxid TiOₓ, Vanadiumoxid VOₓ, Zirkoniumoxid ZrOₓ, Magnesiumoxid MgOₓ, Zinkoxid ZnOₓ, Zinnoxid SnOₓ, Ceroxid CeOₓ, Eisenoxid FeOₓ, Cobältoxid CoOₓ, Wolframoxid WOₓ, Lanthanmanganat LaMnOₓ, Indiumzinnoxid InSnOₓ, Bariumtitanat BaTiOₓ, Calciumcarbonat CaCOₓ sowohl in kristalliner als auch in partiellkristalliner oder amorpher Form einsetzbar sind, wobei der Index x größer als Null und beliebig ist.

11. Verfahren zur Erzeugung von schaltbarem temporärem Magnetismus in oxidischen Materialien mittels elektrischer Felder mit einer Vorrichtung nach Anspruch 1,
**dadurch gekennzeichnet,**
**dass** eine reversible Änderung der Valenz der Kationen, primär durch die räumliche Umverteilung von Sauerstoff-Leerstellen mittels eines dem oxidischen Material (1,2,3) überlagerten elektrischen Feldes (E), bei Raumtemperatur durchgeführt wird und sich die erzeugten magnetischen Momente regelmäßig ausrichten und eine resultierende Magnetisierung (M) erzeugen, wobei durch Schalten des elektrischen Feldes (E) der jeweilige Magnetismus in der Oxidmaterialanordnung (13) reversibel geschaltet und der Ausgangszustand ohne magnetische Momente wiederhergestellt wird.

12. Verfahren nach Anspruch 11,
**dadurch gekennzeichnet,**
**dass** zur Erhöhung der Sauerstoff-Leerstellen-Konzentration positive Ionen ins Kristallgitter des oxidischen Materials eingebracht werden, wobei zur Verkürzung der Zeit der Erzeugung eines registrierfähigen Magnetismus die eingebrachten Ionen eine höhere Beweglichkeit oder höhere Diffusionskonstante aufweisen.

13. Verfahren nach Anspruch 11,
**dadurch gekennzeichnet,**
**dass** durch die Wirkung zusätzlicher elektromagnetischer Felder weitere Sauerstoff-Leerstellen in der Sauerstoff-Leerstellen-Zone (4) und somit weitere magnetische Momente generiert werden.

14. Verfahren nach Anspruch 11,
**dadurch gekennzeichnet,**
**dass** durch Anlegen des elektrischen Feldes (E) von etwa 1000 V/mm die Bildung von Sauerstoff-Leerstellen in der Sauerstoff-Leerstellen-Zone (4) von etwa 10 µm Dicke erfolgt.

15. Verwendung des Verfahrens zur Erzeugung von schaltbarem temporärem Magnetismus nach Anspruch 11,
**dadurch gekennzeichnet,**
**dass** die durch ein elektrisches Feld (E) erzeugten magnetischen Momente an äußere magnetische Felder und nicht zwangsweise aneinander koppeln, womit der magnetische Zustand schaltbar wird, was für Funktionselemente einsetzbar ist.

16. Verwendung nach Anspruch 15,
**dadurch gekennzeichnet,**
**dass** die Oxidmaterialanordnung (13) in einem magnetischen Speicher mit zwei Zuständen eingesetzt wird, wobei das Schreiben durch einen Schreibkopf entfällt, wenn als Zustand "0" das Vorhandensein beliebig ausgerichteter magnetischer Momente definiert wird und Zustand "1" das Fehlen dieser magnetischen Momente darstellt, wobei das Schreiben dann durch An- und Abschalten des elektrischen Feldes (E) und das Auslesen auf magnetischem Wege geschieht.

17. Verwendung nach Anspruch 15,
**dadurch gekennzeichnet,**
**dass** die Oxidmaterialanordnung (13) in einem magnetischen Speicher mit drei Zuständen eingesetzt wird, wobei bei anliegendem elektrischem Feld (E) die magnetischen Momente in der Sauerstoff-Leerstellen-Zone (4) durch Anlegen eines externen Magnetfeldes zur konventionellen magnetischen Datenspeicherung verwendet werden, wobei das Auslesen des magnetischen Speichers wahlweise durch den magnetooptische Effekte oder konventionelle magnetische Leseköpfe (20) erfolgt.

18. Verwendung nach Anspruch 15,
**dadurch gekennzeichnet,**
**dass** die Oxidmaterialanordnung (13) mit einem oxidischen Material (2) in einem magnetisch speichernden Röntgendetektor als Sensoreinrichtung (20) eingesetzt wird, wobei die auftreffenden Röntgenstrahlen (23) punktuell zusätzliche magnetische Momente (24) erzeugen, wobei mittels magnetooptischer Effekte oder magnetischer Leseköpfe dann Intensität und räumliche Verteilung der Röntgenstrahlung (23) registriert werden, indem die Magnetisierung (M) ortsabhängig in der Sauerstoff-Leerstellen-Zone (4) gemessen wird, wodurch die Intensität der eingefallenen Röntgenstrahlung (23) messbar ist.

19. Verwendung nach Anspruch 15,
**dadurch gekennzeichnet,**
**dass** die Oxidmaterialanordnung (13) mit einem oxidischen Material (3) in einer magnetischen Positioniereinheit (25) oder einem Magnetventil oder - schalter eingesetzt wird, wobei oberhalb des kontaktierten oxidischen Materials (3) eine magnetisierbare Platte (26) elastisch gelagert angebracht ist, wobei die im oxidischen Material (3) durch ein externes elektrisches Feld (E) erzeugten magnetischen Momente mit den magnetischen Momenten in der magnetisierbaren Platte (26) wechselwirken und so eine anziehende Kraft (F) auf die magnetisierbare Platte (26) erzeugen, die sich dadurch nach unten bewegt oder bei Abschalten des elektrischen Feldes (E) wieder nach oben, womit die Durchflussgeschwindigkeit/-rate von Gasen und Flüssigkeiten steuerbar sind.

20. Verwendung nach Anspruch 15,
**dadurch gekennzeichnet,**
**dass** die Oxidmaterialanordnung (13) mit einem oxidischen Material (1) für ein Kristallwachstum auf magnetischen Substraten eingesetzt wird, wobei durch ein externes Magnetfeld die im oxidischen Material (1) statistisch verteilten magnetischen Momente vorgegeben ausgerichtet werden, wobei bei Abscheidung einer weiteren magnetisierbaren Schicht sowohl die Kristallstruktur durch epitaktisches Wachstum als auch die magnetische Struktur gezielt weitergegeben werden und nach der Beschichtung das Substrat durch Abschalten oder Umpolen des elektrischen Feldes (E) seine Magnetisierung (M) verliert.

## Claims

1. Apparatus for storing data, consisting of
an apparatus for producing switchable temporary magnetism in oxidic materials by means of electrical fields,
at least one storage element (13), consisting of an oxidic material and at least one electrode (21, 22) attached to each of two opposing surfaces (11, 12) of the oxidic material (1, 2, 3),
wherein upon applying an electrical potential difference the oxidic material (1, 2, 3) is superimposed with the electrical field (E) and thereby an oxide material arrangement (13) is present,
wherein oxygen vacancies, which are already present in the oxidic material (1, 2, 3), are redistributed in the oxidic material (1, 2, 3) when applying the electrical field (E), and thus a gradient of the oxygen concentration develops, producing a measurable electrical current in the oxidic material (1, 2, 3), wherein in a cathode region (14) of the storage element (13) below at least one contacting surface (11) of the oxidic material (1, 2, 3) an oxygen vacancy zone (4) with increased oxygen vacancy concentration is created,
**characterised in that**
in the oxygen vacancy zone (4) the valence of the cations of the oxidic material (1, 2, 3) decreases if the oxygen vacancy concentration increases, and increases if the oxygen vacancy concentration decreases,
wherein a reduction in the valence of the cations in the oxidic material (1, 2, 3) produces magnetic moments (19), which may be present either in a disorganized manner, thereby rendering the oxidic material (1, 2, 3) paramagnetic, or which couple with each other, thereby rendering the oxidic material (1, 2, 3) either ferromagnetic, ferrimagnetic, or antiferromagnetic, and at least one device (15, 20) for detecting the magnetic moments (19) that form in the oxygen vacancy zone (4) due to the applied electrical field (E) and that can be registered is arranged directly outside the cathode region (14) of the oxidic material (1, 2, 3) and the oxygen vacancy zone (4).

2. Apparatus according to claim 1,
**characterised in that**
the device (15, 20) for detecting the magnetism that forms in the oxygen vacancy zone (4) due to the applied electrical field (E) and that can be registered is a sensor device, part of a storage device or part of a switching element.

3. Apparatus according to claim 1 or 2,
**characterised in that**
for increasing the oxygen vacancy concentration, positive ions are added to the crystal lattice of the oxidic material, wherein for reducing the time needed for producing a magnetism that can be registered, the added ions have a higher mobility or higher diffusion constant.

4. Apparatus according to at least one of claims 1 to 3,
**characterised in that**
between the electrodes (21, 22) and the related surface (11, 12) of the oxidic material (1, 2, 3), one intermediate layer (31, 32) made of boron carbide each is attached as a diffusion barrier.

5. Apparatus according to claim 1,
**characterised in that**
the electrical field (E) produces magnetic moments (19), their regular orientation and thereby a magnetisation (M) which is measured or registered by means of the magnetism-responsive device (15, 20).

6. Apparatus according to claim 2,
**characterised in that**
the sensor device (15) utilises the magneto-optic Kerr effect or Faraday effect, wherein one light source (6) emits polarised light (7) penetrating the entire oxide material arrangement (13) consisting of the oxidic material (1, 2, 3), the electrodes (21, 22), the diffusion barriers (31, 32) and the oxygen vacancy zone (4) present in the oxidic material (1, 2, 3), wherein the reflected or transmitted light (8) is changed in polarisation and ellipticity due to the magnetisation (M) present in the oxygen vacancy zone (4) in a site-specific manner and wherein a detector (9) registers the changes and thereby the magnetisation (M) produced in a site-specific manner.

7. Apparatus according to claim 1,
**characterised in that**
the device (20) for detecting the magnetism is a magnetic read head which alternatively allows to measure the magnetisation (M).

8. Apparatus according to claim 7,
**characterised in that**
alternatively, the oxide material arrangement (13) is inserted into a coil (16) for registering the magnetisation (M), which registers the magnetic field produced by the magnetisation by way of an induced voltage (V) in a voltmeter (17).

9. Apparatus according to claim 7,
**characterised in that**
alternatively, the oxide material arrangement (13) is inserted into a coil (16) for registering the magnetic state, which registers the magnetisation (M) produced by an external magnetic field by way of an induced voltage (V) in a voltmeter (17).

10. Apparatus according to claim 1,
**characterised in that**
as the oxidic material (1, 2, 3), strontium titanate SrTiOₓ, titanium oxide TiOₓ, vanadium oxide VOₓ, zirconium oxide ZrOₓ, magnesium oxide MgOₓ, zinc oxide ZnOₓ, tin oxide SnOₓ, cerium oxide CeOₓ, iron oxide FeOₓ, cobalt oxide CoOₓ, tungsten oxide WOₓ, lanthanum manganate LaMnOₓ, indium tin oxide InSnOₓ, barium titanate BaTiOₓ. calcium carbonate CaCOₓ can be used both in crystalline and partially crystalline or amorphous form, wherein the index x is greater than zero and arbitrary.

11. Method for producing switchable temporary magnetism in oxidic materials by means of electrical fields with an apparatus according to claim 1,
**characterised in that**
a reversible valence change of the cations, primarily due to the spatial redistribution of oxygen vacancies by means of an electrical field (E) superimposed on the oxidic material (1, 2, 3), is created at room temperature, and the produced magnetic moments align regularly and produce a resulting magnetisation (M), wherein by switching the electrical field (E) the respective magnetism in the oxide material arrangement (13) is reversibly switched and the original state is restored without magnetic moments.

12. Method according to claim 11,
**characterised in that**
for increasing the oxygen vacancy concentration, positive ions are added to the crystal lattice of the oxidic material, wherein for reducing the time needed for producing a magnetism that can be registered, the added ions have a higher mobility or higher diffusion constant.

13. Method according to claim 11,
**characterised in that**
through the effect of additional electromagnetic fields, further oxygen vacancies are generated in the oxygen vacancy zone (4) and thus further magnetic moments.

14. Method according to claim 11,
**characterised in that**
by applying the electrical field (E) of around 1000 V/mm, oxygen vacancies are formed in the oxygen vacancy zone (4) with a thickness of around 10 µm.

15. Use of the method for producing switchable temporary magnetism according to claim 11,
**characterised in that**
the magnetic moments produced by way of an electrical field (E) couple with external magnetic fields and not necessarily with each other rendering the magnetic state switchable which can be used for functional elements.

16. Use according to claim 15,
**characterised in that**
the oxide material arrangement (13) is used in a magnetic storage with two states, wherein writing by means of a write head is omitted if the presence of arbitrarily oriented magnetic moments is defined as state "0" and the absence of such magnetic moments represents state "1", wherein writing then occurs by switching the electrical field (E) on and off and reading occurs magnetically.

17. Use according to claim 15,
**characterised in that**
the oxide material arrangement (13) in a magnetic storage is used with three states, wherein upon applying an electrical field (E) the magnetic moments in the oxygen vacancy zone (4) are used by applying an external magnetic field for conventional magnetic data storage, wherein reading of the magnetic storage optionally either occurs by way of the magneto-optic effect or conventional magnetic read heads (20).

18. Use according to claim 15,
**characterised in that**
the oxide material arrangement (13) with an oxidic material (2) is used in a magnetically storing X-ray detector as a sensor device (20), wherein the incident X-rays (23) produce additional localised magnetic moments (24), wherein by means of magneto-optic effects or magnetic read heads the intensity and spatial distribution of the X-rays (23) is then registered by measuring the magnetisation (M) in the oxygen vacancy zone (4) in a site-specific manner, whereby the intensity of the incident X-rays (23) can be measured.

19. Use according to claim 15,
**characterised in that**
the oxide material arrangement (13) with an oxidic material (3) is used in a magnetic positioning unit (25) or a solenoid valve or switch, wherein above the contacted oxidic material (3) an elastically supported magnetisable plate (26) is attached, wherein the magnetic moments produced in the oxidic material (3) due to an external electrical field (E) interact with the magnetic moments in the magnetisable plate (26), thus producing an attracting force (F) on the magnetisable plate (26) which it causes to move down or, when switching off the electrical field (E), up again, rendering the flow velocity/rate of gases and liquids controllable.

20. Use according to claim 15,
**characterised in that**
the oxide material arrangement (13) with an oxidic material (1) is used for crystal growth on magnetic substrates, wherein due to an external magnetic field the magnetic moments statistically distributed in the oxidic material (1) are oriented in a predetermined manner, wherein when separating a further magnetisable layer both the crystal structure based on epitaxial growth and the magnetic structure are passed on in a targeted manner and after coating when switching off or reversing the polarity of the electrical field (E) the substrate loses its magnetisation (M).

## Revendications

1. Dispositif d'enregistrement de données composé
d'un dispositif de production d'un magnétisme temporaire commutable dans un matériau de type oxyde à l'aide de champs électriques,
d'au moins d'un élément d'enregistrement (13) composé d'un matériau de type oxyde et au moins respectivement à une électrode appliquée (21,22) au deux surfaces (11,12) du matériau de type oxyde (1,2,3),
lors de l'application d'un potentiel différentiel électrique, le matériau de type oxyde (1,2,3) étant superposé par le champ électrique (E) et donnant ainsi une disposition de matériaux de type oxyde,
les lacunes en oxygène existant déjà dans le matériau de type oxyde (1,2,3) étant redistribuées lors de l'application du champ électrique (E) dans le matériau de type oxyde (1,2,3) et ainsi un gradient de la concentration d'oxygène se formant, se traduisant par un courant électrique mesurable dans le matériau de type oxyde (1, 2, 3),
une zone de lacunes d'oxygène (4) à concentration élevée de lacunes d'oxygène se formant dans une zone de cathodes (14) de l'élément d'enregistrement (13) au moins sous la surface de contact (11) du matériau de type oxyde (1,2,3),
**caractérisé en ce que**
la valence des cations du matériau de type oxyde (1,2,3) se réduit dans la zone de lacunes d'oxygène (4) lorsque la concentration de lacunes d'oxygène augmente et diminue lorsque la concentration de lacunes d'oxygène diminue,
une réduction de la valence des cations dans le matériau de type oxyde (1,2,3) générant des moments magnétiques (19) qui sont soit subordonnés, le matériau de type oxyde (1,2,3) devenant ainsi paramagnétique, ou s'accouplent entre eux, le matériau de type oxyde (1,2,3) devenant soit ferromagnétique, ferri-magnétique ou antiferromagnétique et
au moins un dispositif (15,20) de saisie des moments magnétiques (19) se formant dans la zone de lacunes d'oxygène (4) par le champ électrique appliqué (E) et enregistrables étant placé directement hors de la zone de cathodes (14) du matériau de type oxyde (1,2,3) et de la zone de lacunes d'oxygène (4).

2. Dispositif selon la revendication 1,
**caractérisé en ce**
**que** le dispositif (15,20) de saisie du magnétisme se formant dans la zone de lacunes d'oxygène (4) par le champ électrique appliqué (E) et enregistrable représente un dispositif de détection, une partie d'un dispositif d'enregistrement et une partie d'un élément de commutation.

3. Dispositif selon la revendication 1 ou 2,
**caractérisé en ce**
**que** pour augmenter les lacunes en oxygène, des ions positifs sont apportés dans le réseau cristallin du matériau de type oxyde, pour réduire la durée de la production d'un magnétisme enregistrable, les ions apportés présentant une mobilité plus élevée ou un coefficient de diffusion plus élevé.

4. Dispositif selon au moins l'une des revendications 1 à 3,
**caractérisé en ce**
**qu'**entre les électrodes (21,22) et la surface associée (11,12) du matériau de type oxyde (1,2,3), une couche intermédiaire (31,32) en carbure de bore est respectivement appliquée en tant que barrière de diffusion.

5. Dispositif selon la revendication 1,
**caractérisé en ce**
**que** le champ électrique (E) produit des moments magnétiques (19), leur orientation régulière et donc une magnétisation (M) qui est mesurée ou enregistrée par le dispositif (15,20) réagissant au magnétisme.

6. Dispositif selon la revendication 2,
**caractérisé en ce**
**que** le dispositif de détection (15) utilise l'effet Kerr magnéto-optique ou l'effet Faradaye, une source lumineuse (6) émettant une lumière polarisée (7) qui transperce l'ensemble de la disposition du matériau de type oxyde (13) composée du matériau de type oxyde (1,2,3), des électrodes (21,22), des barrières de diffusion (31,32) et de la zone de lacunes d'oxygène (4) contenue dans le matériau de type oxyde (1,2,3), la lumière (8) réfléchie ou transmise étant modifiée en polarisation et ellipticité par la magnétisation (M) existant dans la zone de lacunes d'oxygène (4) en fonction de l'endroit et un détecteur (9) enregistrant les modifications et ainsi la magnétisation (M) produite en fonction de l'endroit.

7. Dispositif selon la revendication 1,
**caractérisé en ce**
**que** le dispositif (20) de saisie du magnétisme représente une tête de lecture magnétique avec laquelle alternativement la magnétisation (M) peut être mesurée.

8. Dispositif selon la revendication 7,
**caractérisé en ce**
**qu'**alternativement, la disposition du matériau de type oxyde (13) est introduit dans une bobine (16) pour enregistrement de la magnétisation (M) qui enregistre le champ magnétique produit par la magnétisation par l'intermédiaire d'une tension (V) induite se trouvant dans un voltmètre (17).

9. Dispositif selon la revendication 7,
**caractérisé en ce**
**qu'**alternativement, la disposition du matériau de type oxyde (13) est introduit dans une bobine (16) pour enregistrement de l'état magnétique qui enregistre la magnétisation (M) générée par un champ magnétique extérieur par l'intermédiaire d'une tension (V) induite se trouvant dans un voltmètre (17).

10. Dispositif selon la revendication 7,
**caractérisé en ce**
**que** en tant que matériaux de type oxyde (1,2,3), on peut utilisé du tritanate de strontium SrTiOₓ, de l'oxyde de titane TiOₓ, de l'oxyde de vanadium VOₓ, de l'oxyde de zirconium ZrOₓ, de l'oxyde de magnésium MgOₓ, de l'oxyde de zinc ZnOₓ, de l'oxyde stannique SnOₓ, de l'oxyde céreux CeOₓ, de l'oxyde ferreux FeOₓ, de l'oxyde de cobalt CoOₓ, de l'oxyde de tungstène WOₓ, du manganate de lanthane LaMnOₓ, de l'oxyde de stannique d'indium InSnOₓ, du tritanate de barium BaTiOₓ, du carbonate de calcium CacOₓ pouvant être utilisés tant sous forme cristalline que sous forme partiellement cristalline ou amorphe, l'indice x étant supérieur à zéro et pouvant avoir valeur quelconque.

11. Procédé de production d'un magnétisme temporaire commutable dans des matériaux de type oxyde à l'aide de champs électriques avec un dispositif selon la revendication 1,
**caractérisé en ce**
**que** la modification réversible de la valence des cations est effectuée primairement par la redistribution spatiale de lacunes en oxygène par l'intermédiaire du champ électrique (E) superposant l'un des matériaux de type oxyde (1,2,3) à une température de salle et que les moments magnétiques produits s'ajustent régulièrement et produisent une magnétisation (M) résultante, le magnétisme respectif dans la disposition du matériau de type oxyde (13) se commutant de façon réversible, par commutation du champ électrique (E) et l'état initial étant rétabli sans moments magnétiques.

12. Procédé selon la revendication 11,
**caractérisé en ce**
**que** pour augmenter la concentration de lacunes d'oxygène, des ions positifs sont incorporés dans le réseau cristallin du matériau de type oxyde, les ions incorporés présentant une mobilité plus élevée ou une constante de diffusion plus élevée pour réduire la durée de la production d'un magnétisme enregistrable.

13. Procédé selon la revendication 11,
**caractérisé en ce**
**que** par l'effet de champs électromagnétiques supplémentaires, d'autres lacunes en oxygène se trouvant dans la zone de lacunes d'oxygène (4) et donc d'autres moments magnétiques sont produits.

14. Procédé selon la revendication 11,
**caractérisé en ce**
**que** par l'application du champ électrique (E) d'environ 1000 V/mm, des lacunes en oxygène d'une épaisseur d'environ 14 µm se forment dans la zone de lacunes d'oxygène (4).

15. Utilisation du procédé de production d'un magnétisme temporaire commutable selon la revendication 11,
**caractérisée en ce**
**que** les moments magnétiques produits par un champ électrique (E) sont couplés à des champs magnétiques extérieurs et pas nécessairement l'un à l'autre, l'état magnétique devenant ainsi commutable, ce qui est utilisable pour les éléments de fonction.

16. Utilisation selon la revendication 15,
**caractérisée en ce**
**que** la disposition du matériau de type oxyde (13) est utilisée dans une mémoire magnétique avec deux états, l'écriture par une tête d'écriture étant supprimée lorsqu'à l'état « 0 », la présence de moments magnétiques à orientation quelconque est définie et que l'état « 1 » représente l'absence de ces moments magnétiques, l'écriture s'effectuant par l'activation et la désactivation du champ électrique (E) et la lecture s'effectuant par voie magnétique.

17. Utilisation selon la revendication 15,
**caractérisée en ce**
**que** la disposition du matériau de type oxyde (13) est utilisée dans une mémoire magnétique avec trois états ; par application du champ électrique (E), les moments magnétiques dans la zone de lacunes d'oxygène (4) étant utilisés par application d'un champ magnétique externe pour mémorisation magnétique conventionnelle ; la lecture de la mémoire magnétique s'effectuant au choix par les effets magnéto-optiques ou les têtes de lecture (20) magnétiques conventionnelles.

18. Utilisation selon la revendication 15,
**caractérisée en ce**
**que** la disposition du matériau de type oxyde (13) est utilisée avec un matériau de type oxyde (2) dans un détecteur à rayons X à enregistrement magnétique en tant que dispositif de détection (20), les rayons X (23) apparaissants produisant ponctuellement des moments magnétiques (24) supplémentaires; l'intensité et la répartition spatiale du rayonnement X (23) étant enregistrées à l'aide des effets magnéto-optiques ou des têtes de lecture magnétiques par mesure de la magnétisation (M) en fonction de l'endroit dans la zone de lacunes d'oxygène (4) permettant ainsi de mesurer l'intensité du rayonnement X (23) incident.

19. Utilisation selon la revendication 15,
**caractérisée en ce**
**que** la disposition du matériau de type oxyde (13) est utilisée avec un matériau de type oxyde (3) dans une unité de positionnement magnétique (25) ou une électrovanne ou un interrupteur magnétique ; au-dessus du matériau de type oxyde (3) ayant contact, une plaque magnétisable (26) étant installée de façon élastique ; les moments magnétiques produits dans le matériau de type oxyde (3) par un champ électrique externe (E) interagissant avec les moments magnétiques de la plaque magnétisable (26) et produisant ainsi une force d'attraction (F) sur la plaque magnétisable (26) qui se déplace ainsi vers le bas ou en cas de désactivation du champ électrique (E) retourne vers le haut, la vitesselle taux de débit des gaz ou des liquides pouvant être de ce fait piloté.

20. Utilisation selon la revendication 15,
**caractérisée en ce**
**que** la disposition du matériau de type oxyde (13) est utilisée avec un matériau de type oxyde (1) pour une croissance cristalline sur des substrats magnétiques ; un champ magnétique externe orientant de façon prescrite les moments magnétiques répartis statiquement dans matériau de type oxyde (1) ; lors de la séparation d'une autre couche magnétisable, tant la structure cristalline, par croissance épitactique, que la structure magnétique sont transmises de façon ciblée et après le revêtement, le substrat perd sa magnétisation (M) par désactivation ou inversement de polarité du champ électrique (E).
